# EUROPEAN PATENT SPECIFICATION

(11) **EP 0 365 874 B1**
(45) Date of publication and mention of the grant of the patent: **21.07.1993**
(21) Application number: 89118302.2
(22) Date of filing: 03.10.1989
(51) Int. Cl.: G01N 21/88, G01R 31/28

(54) **Optical inspection system for solder joints and inspection method**
Verfahren und Vorrichtung zur optischen Untersuchung von Lötstellen
Système et méthode d'inspection optique des sondures

(30) Priority: 03.10.1988 US 252476
(43) Date of publication of application: 02.05.1990
(73) Proprietor: Hughes Aircraft Company, Los Angeles, California 90045-0066 (US)
(72) Inventor: Doan, Tam D., Orange California 92669 (US)
(74) Representative: Witte, Alexander, Dr.-Ing.

(56) References cited:
- US-A- 4 672 437
- IBM TECHNICAL DISCLOSURE BULLETIN, vol. 30, no. 2, July 1987, page 626; "Illumination method for inspecting solder bounds of surface-mounted components"
- PATENT ABSTRACTS OF JAPAN, vol. 355, no. 11, 19th November 1987 (E-558); & JP-A-62 131 672
- PATENT ABSTRACTS OF JAPAN, vol. 10, no. 322, 31st October 1986 (P-511)[2378]; & JP-A-61 128 143
- PATENT ABSTRACTS OF JAPAN, vol. 10, no. 220, 31st July 1986 (P-482)[2276]; & JP-A-61 57 839

## Description

The invention relates to an optical inspection system.

The invention, further, relates to a method of optically inspecting a solder joint.

Much of modern electronic assembly is automatic. A robot with specially fabricated grasping fingers grasps a selected electronic component from a dispensing station. This component may be a flat pack with a plurality of flat leads extending from one or more sides thereof or may be a cylindrical component such as a resistor having round wire leads thereon. The leads of the components are shaped in such a manner that they lie at or below the bottom surface of the component for surface mounting on the printed wiring board. After they are grasped, the component may be optically inspected so that it is the correct component for this particular assembly step. Next, the component may have its leads fluxed, and thereafter the component is put in place on the printed wiring board. When it is put in place, its leads are located on solder pads which have sufficient solder thereon for reflow soldering to the leads on the component. When placed, heater bars are brought over the component leads and are brought down on the leads to hold them in place. While held in place, the heater bars heat the leads and the adjacent solder to reflow solder the leads in place. The assembly complete, except for the inspection of the adequacy of the solder joint. Present inspection to some extent is visual. The inspection is by employment of microscopes having magnification of under four times to microscopes having magnification of seven times. Illumination is normal microscope illumination, about 45 degrees to the normal to the surface of the printed wiring board. This is the best quality control inspection presently available, but its disadvantages include the subjectivity of the inspection and the personal judgement required. This is compounded by limited visual acuity and limited attention span. The article must be manually moved with respect to the microscope which can cause hand-eye coordination errors. Each of the errors increases with fatigue as the work day goes on. As a result of this, an accept-reject decision cannot be repeated with 100 percent repeatability. In addition, such inspection methods are labor intensive and require expensive training together with periodic certification of the trained inspectors.

There have been attempts to automatically inspect by means of laser illumination together with infra-red signature sensing and analysis technique. The problem with the infrared inspection technique is that it cannot detect all visual defects. It is not as sensitive to problems as a good visual inspection. It cannot detect extraneous solder, away from the solder pads. It cannot detect subtle visual solder defects such as insufficient solder or dewet conditions, where the solder does not wet both surfaces of the intended solder joint. Further, it cannot detect misalignment between the leads and the pads. Other attempts at automatic inspection include the use of two colors of light at different illumination angles, but have not been reliable to date.

Document IBM Technical Disclosure Bulletin, Vol. 30, No. 2, July 1987, page 626, describes an illumination method for inspecting solder bonds of surface-mounted components. According to the method a circular lamp is positioned between a CCD camera and a card supporting the surface-mounted components. The circular lamp is provided with a reflector thus providing continuous illumination from all directions in the angle range of about 15° to about 55° with respect to the card.

Document US-A-4 672 437 discloses an optical inspection system to be used in the inspection of packaged integrated circuits. The system comprises a video camera which is connected to a miniature fibre optic bundle for transmitting a video signal. The video signal is transmitted to a digital image processing unit which can enhance the image quality before displaying the video signal on a monitor to ease the package inspection for the human observer. In order to automate the inspection process, the integrated circuit package is mounted on a positioning stage, the motion of which with respect to the fibre optic bundle being controlled by a computer. Thus, one solder bond after the other is moved close to the fibre optic bundle in order to be inspected. For bringing illuminating light directly to the specific area to be inspected, a second fibre optic bundle is used which is directly attached in parallel to the first fibre optic bundle for transmitting the optical image. For further automating the inspection process, the video signal is fed to a computer. A pattern recognition program is used to compare the digital image processor signal to a pre determined inspection criterion. The computer can thus reject or accept the package being inspected based on a comparation.

Document JP-A-62 131 672 discloses a picture input device for obtaining images with sufficient contrast from an object including mirror surfaces such as solder platings. The device determines the boundary lines of the mirror surfaces and controls a positioning table supporting the object in order to bring the object in a prescribed position. For this purpose, a TV camera observes the object from just above, and light is irradiated from just beside the object. Thus, light reflected from the mirror surface will not enter the camera, whereas light reflected from the boundary will do so. Thus, a strong contrast is obtained from the boundary line.

Document JP-A-61 128 143 discloses a method for inspecting the quality of a soldered part. The image data of the soldered part to be inspected are successively compared with preliminary stored proper image data of a properly soldered part. When the number of differences exceeds a predetermined value, the soldered part is judged to be deficient.

Finally, document JP-A-6 157 839 discloses a device for inspecting the outer appearance of an object. The object to be inspected is illuminated and observed from above.

It is, therefore, an object of this invention to further improve a system and a method of the kind mentioned at the outset to allow still more reliable and automatic inspection and control of solder joints by providing digitized information that can easily be interpreted automatically.

According to the system, mentioned at the outset, this object is achieved by:
- support means for the location of a printed wiring board having surface-mounted components thereon being provided with solder joints;
- an optical-electronic transducer defining an inspection axis normal with respect to said support means and being positioned to receive an optical solder joint image along said inspection axis and adapted to convert said optical solder joint image into an electronic image signal; and
- a light source positioned between said printed wiring board and said optical-electronic transducer for illuminating said solder joint with respect to said inspection axis such that light from said light source impinges on flat surfaces of said board and of elongate component leads, respectively, under a low angle with respect to said flat surfaces to prevent reflection therefrom into said optical-electronic transducer, whereas light from said light source impinging on concave surfaces of solder joint fillets adjoining said elongate component leads are reflected into said optical-electronic transducer thus creating said optical solder joint image with dark areas representing said flat surfaces and bright bands representing said concave fillet surfaces;
- means for digitizing said electronic image signal and for converting same into a digitized information;
- means for analyzing said digitized information to evaluate the adequacy of said solder joint, said analyzing means being configured to detect completeness of said bands along said component leads; and
- completion signal means generating a completion and acceptance signal when said completeness corresponds to a continuous band along a predetermined proportion of the total fillet length.

According to the method, mentioned at the outset, this object is achieved by the steps of:
- positioning on an inspection axis and perpendicularly thereto a printed wiring board having a pad thereon
   with a component lead on said pad purportedly soldered to said pad by means of solder fillets extending along said lead between said pad and said lead, said printed wiring board and said lead having flat surfaces, whereas said fillets have concave surfaces;
- positioning a lamp to provide low angle light onto said pad so that reflection from said flat surfaces of said printed wiring board and said lead do not directly reflect on the optical axis, whereas reflection from said solder fillets reflects on said optical axis, thus creating an optical solder joint image with dark areas representing said flat surfaces and bright bands representing said concave fillet surfaces;
- transducing said optical image to a digitized optical information;
- analyzing said digitized optical information to evaluate the adequacy of said solder joint by detecting completeness of said bands along said component leads; and
   generating a completion and acceptance signal when said completeness corresponds to a continuous band along a predetermined proportion of the total fillet length.

Due to the diffused low angle light, the differences in observed high-contrast images are sufficient to permit computer analyses of the image. The diffused low angle lighting will reliably illuminate the concave fillets and the good solder joints while illuminating nothing else.

In order to aid in the understanding of this invention, it can be stated in essentially summary form that it is directed to an optical inspection system for solder joints and to an inspection method wherein the system comprises illuminating the solder joint with diffuse light at a low angle with respect to the normal to the surface of the print wiring board, employing a video camera to transduce the image to electronic signals, digitizing the signals using an image processor, and processing and analyzing the image data to determine whether or not the image of the solder joint indicates a satisfactory solder joint so that automatic solder joint inspection and evaluation of the joint is achieved.

It is another purpose and advantage of this invention to provide a system where the quality of solder joints of various components can be inspected without the involvement of machine down time for adjustment between types of solder joints.

It is another purpose and advantage of this invention to provide an optical inspection system for solder joints which removes the subjectivity and judgment, as well as the fatigue and limited visual acuity attendant upon visual inspection.

Other purposes and advantages of this invention will become apparent from a study of the following portion of the specification, the claims and the attached drawings.

FIG. 1 is a perspective view of an inspection station having the optical inspection system of this invention therein, together with some of the system shown in block diagram.

FIG. 2 is an enlarged section through the inspection station, showing the solder joint being inspected and a portion of the optical inspection system.

FIG. 3 is a plan view of two solder joints as seen by the inspection system with the lighting of this invention, showing an unsoldered joint and a soldered joint.

FIG. 4 is a plan view of the same two joints, illuminated at 45 degrees to the normal in accordance with modern visual inspection.

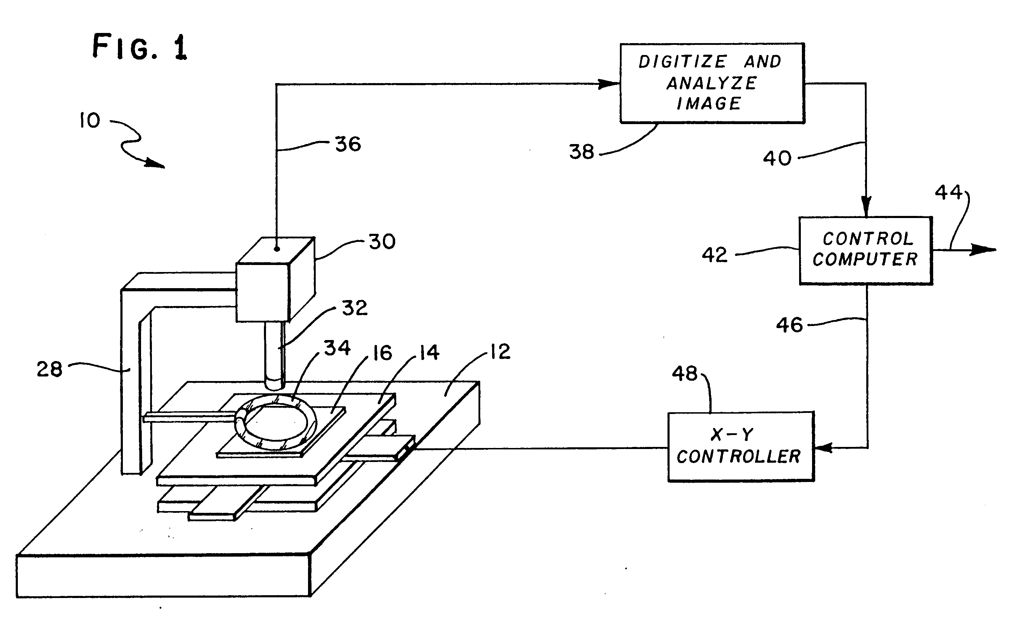

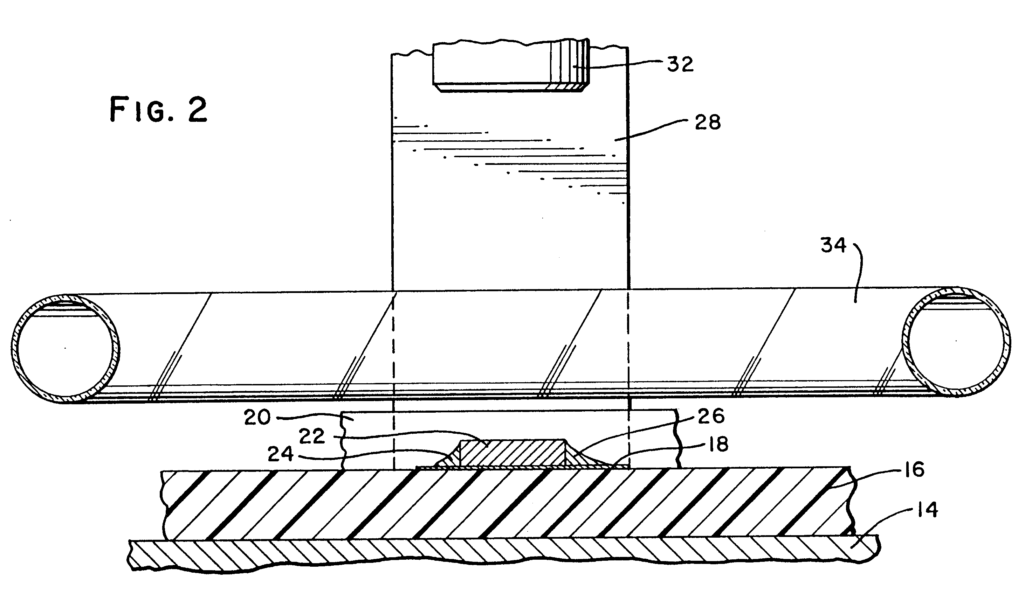

In FIG. 1, the optical inspection system of this invention is generally indicated at 10. The system comprises an optical portion and an electronic portion connected by an optical-electronic transducer, such as a black and white video camera. The inspection takes place at an inspection station which includes table 12, which may be part of an assembly system. The top of the table represents the X and Y orthogonal coordinates, and the Z coordinate is normal thereto. Positioned on table 12 is platform 14, which is movable on X and Y coordinates, normal to the Z coordinate, to position a particular location on the inspection axis. The subject matter being inspected is the adequacy of the solder joint between leads on an electrical component and pads on the printed wiring board. Printed wiring board 16 is mounted on the table by means of a suitable fixture. It carries thereon a plurality of solder pads, one of which is seen at 18 in FIG. 2. In the usual processing, solder pad 18 has sufficient solder thereon prior to the soldering operation that, when a lead is placed thereon and heat is applied, the solder melts and fills the gap between the lead and the pad. In the present case, a portion of a component 20 is shown in FIG. 2. It has a rectangular lead 22 extending therefrom and positioned on pad 18. Previously to the positioning of the lead on the pad, suitable cleaning and fluxing have taken place to normally result in good solder attachment. Heater bars have been placed upon the lead 22 and heat applied so that solder has reflowed from the pad to wet and join both the pad and the lead. Fillets 24 and 26 are representative of good soldering. It is to be noted that the fillets are concave in the upward direction and outward from the lead. While the rectangular lead is shown, a round wire lead has similar fillets when properly soldered on a pad.

Stand 28 supports video camera 30 above the lead. The lens 32 of the video camera defines the axis at the center of the video field. The X-Y platform 14 moves the lead 22 onto the axis for video observation. Illumination is provided by a lamp which provides low angle diffuse illumination all around the area being inspected. Circular fluorescent lamp 34 is preferred. A high intensity, small diameter lamp is required. It provides light at a low angle with respect to the top of the printed wiring board 16 by being positioned as low as possible closely over the printed wiring board 16 as clearances permit. A specific example of a suitable light is a 3-1/2 inch (8,89 cm) diameter, 40 watt "Light Mite" circular high intensity fluorescent lamp. The large and diffused fluorescent lamp distributes light intensity evenly over a large area thereby eliminating confusing shadows and specular reflections. The light source from the circular fluorescent lamp is at such a low angle with respect to the top of the board so that light therefrom does not provide upward reflection from flat and horizontal surfaces. It is to be noted, however, that the concave surfaces of fillets 24 and 26 reflect a substantial part of the incident light upwardly. The top surfaces of the lead 22 and of the printed wiring board are thus comparatively dark and the concave surfaces of the proper fillets are comparatively bright. Hence the features of interest are distinct from background and non-features and the edges of the lead are distinctly contrasted from the fillets.

The video camera 30 with its lens 32 is directed at the lead and convert that image of light and dark to a video signal. The video signal is present in line 36. A black and white camera is adequate because the image scene is a high contrast image without significant color. A color camera can be used to detect organic contamination or exposed copper. A video monitor can be connected to video signal line 36, but such is merely for observation and is not an essential part of the present inspection system. The video signal on line 36 is an analog signal, with line-by-line scan information interspersed therein. This analog information is difficult to process and interpret. Thus, it is fed to digitizer 38 where the image information is translated to digital signals. Furthermore, digitizer 38 includes an image analyzer to determine the quality of the solder joint. The analyzer accepts or rejects the solder joint on the basis of satisfying one rule, which requires fillet along a Predetermined portion of the length of the lead. In commercial work, a 60 percent continuity of fillet is adequate. In high reliability work, a higher continuity is required. The absence of reflection from a significant length of the fillet indicates the inadequacy of fillet, and thus indicates the absence of a proper solder joint.

When the analysis of one particular lead connection has been completed, an output in quality control line 40 signals the adequacy or inadequacy of the inspected solder joint to control computer 42. The control computer 42 has an output signal line 44 by which the information as to the acceptability of the particular solder joint is recorded. It also provides an output signal in proceed line 46 which signals the X-Y controller 48 to move the X-Y platform to a new position wherein a new lead is on the inspection axis. Thus, the control computer 42 relates the quality decision to the particular solder joint and provides the go-ahead information. A continuous loop is formed, and when the X-Y controller has a new lead on the inspection axis, the optical signal is digitized, analyzed, and informs the control computer 42 that is ready to have its information recorded and proceed to the next solder joint. Such inspections are thus of individual leads and progress rapidly so that inspection rates are an order of magnitude faster than visual inspection rate. With a more complex inspection program, more than one soldered lead can be inspected at a time.

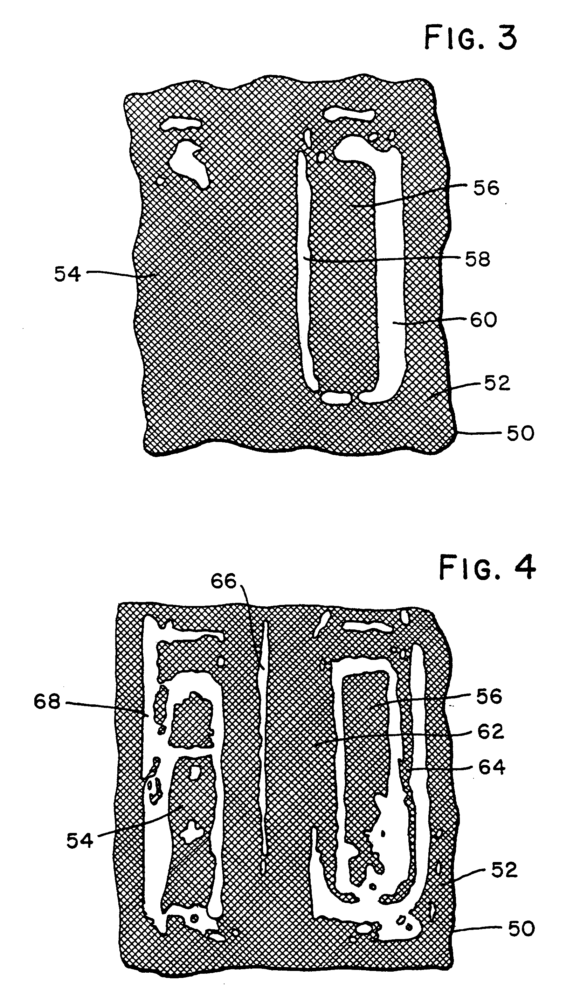

FIG. 3 is a plan view of first and second adjacent rectangular component leads soldered onto pads on a printed circuit board, illuminated in the manner described above and shown in FIGS. 1 and 2.

FIG. 4 is a plan view of the same two the component leads and solder condition, illuminated from an angle above 45 degrees to the top face of the printed wiring board in the conventional way. Two leads are shown in these figures, the leads being adjacent each other on the edge of a component package and being presumptively soldered to adjacent pads on the printed wiring board. This is illustrative of the camera view resulting from the two types of lighting. In the system described above, only one solder joint would be inspected at a time. The two leads thus represent successive inspection areas. The printed wiring board is shown at 50 in FIGS. 3 and 4, and its top surface 52 shows up as black on a high-contrast image because little light reflects therefrom with low angle lighting. The area 54 in FIGS. 3 and 4 is the top surface of the first lead. IN FIG. 3 with low angle lighting, it appears continuous with the background, which is represented by the top surface of the printed wiring board. The lead surface 54 is also shown in FIG. 4. Lead surface 56 is the top of the second lead in each of the images. The second lead with top surface 56 is properly soldered, and the concave surfaces of the fillet, such as shown at 24 and 26 in FIG. 2, reflect the diffuse low angle lighting upward to show bands 58 and 60. These are bright bands and are white in a high-contrast image system, as provided in the present invention. These bright bands represent proper soldering and an adequate fillet. These areas should be compared with the dark bands 62 and 64, which are the solder fillets and show up as dark bands on the high angle lighted image of FIG. 4. If these dark bands are to be interpreted as proper solder joints, then they must be outlined by the bright band seen at the right of FIG. 4. These bright bands correspond to the edges of the fillet. The random white spots correspond to reflections from the pads. For example, in FIG. 4, light band 66 is a reflection from the top of the solder pad, and the light band 68 is also a reflection from the pad. The lead on the left is inadequately soldered, and this clearly shows up in FIG. 3 where little reflection is observed. There is no solder fillet to reflect the low angle lighting. Thus, the flat surfaces and square edges of the component lead and solder pad are not seen in FIG. 3, as they are in FIG. 4.

From this observation of the two leads, with the left one having an inadequate solder attachment and the right one having an adequate solder attachment, it is apparent that the differences in observed high-contrast image are insufficient with high angle light and sufficient with low angle light to permit computer analysis of the image produced when low angle illumination is employed. The diffused low angle lighting will reliably illuminate the concave fillets of the good solder joints while illuminating nothing else.

The high angle lighting will not reliably illuminate the concave fillets, sometimes introducing confusing shadows and specular glares into the image. It also illuminates the features of the bad or missing fillets. The results are complex and confusing images without differentiating the good and bad features.

On the contrary, the low angle diffused lighting brightens the features of the good fillets (i.e. concave surfaces) while darkening the features of bad fillets or non-features. The effects are wider dynamic range of electronic signals between bad and good features, thereby facilitating discriminating the good from the bad joints. The electronic analog television images are digitized, and the shape thereof and completeness of the bands is analyzed to determine compliance to a rule which requires a continuous fillet along a predetermined proportion of the total potential fillet length. When the standard has been met, a completion signal and an acceptance signal are emitted in line 40 to the control computer where the acceptance of that particular solder joint is recorded and the X-Y controller is instructed to move another solder joint onto the inspection axis. In this way, rapid, automatic, reliable inspection is achieved.

## Claims

1. An optical inspection system comprising:
- support means (12, 14) for the location of a printed wiring board (16; 50) having surface-mounted components (20) thereon being provided with solder joints;
- an optical-electronic transducer (30, 32) defining an inspection axis normal with respect to said support means (12, 14) and being positioned to receive an optical solder joint image along said inspection axis and adapted to convert said optical solder joint image to an electronic image signal;
- a light source positioned between said printed wiring board (16; 50) and said optical-electronic transducer (30, 32) for illuminating said solder joint with respect to said inspection axis such that light from said light source impinges on flat surfaces (52, 54, 56) of said board (16; 50) and of elongate component leads (22), respectively, under a low angle with respect to said flat surfaces (52, 54, 56) to prevent reflection therefrom into said optical-electronic transducer (30, 32) whereas light from said light source impinging on concave surfaces of solder joint fillets (24, 26) adjoining said elongate component leads (22) are reflected into said optical-electronic transducer (30, 32) thus creating said optical solder joint image with dark areas representing said flat surfaces (52, 54, 56) and bright bands (58, 60) representing said concave fillet surfaces;
- means (38) for digitizing said electronic image signal and for converting same into a digitized information;
- means (38) for analyzing said digitized information to evaluate the adequacy of said solder joint, said analyzing means (38) being configured to detect completeness of said bands (58, 60) along said component leads (22); and
- completion signal means generating a completion and acceptance signal when said completeness corresponds to a continuous band along a predetermined proportion of the total fillet length.

2. The system of claim 1, characterized in that said light source is a low-diameter, high-intensity circular fluorescent lamp (34) positioned around said axis.

3. The system of claim 2, characterized in that said circular fluorescent lamp (34) is positioned closely above said support means (12, 14) to provide low angle diffuse illumination substantially all the way around said axis.

4. The system of any of claims 1 - 3, characterized in that said support means is a positioning table (12, 14) and that said analyzing means (38) is connected to said positioning table (12, 14) so that when the analysis of a solder joint is complete, said positioning table (12, 14) upon occurrence of said completion and acceptance signal moves to a position where a new pad (18) and its component lead (22) are on said axis.

5. A method of optically inspecting a solder joint, comprising the steps of:
- positioning on an inspection axis and normal thereto a printed wiring board (16; 50) having a pad (18) thereon with a component lead (22) on said pad (18) purportedly soldered to said pad (18) by means of solder fillets (24, 26) extending along said lead (22) between said pad (18) and said lead (22), said printed wiring board (16; 50) and said lead (22) having flat surfaces (52, 54, 56) whereas said fillets (24, 26) have concave surfaces;
- positioning a lamp (34) to provide low angle light onto said pad (18) so that reflection from said flat surfaces (52, 54, 56) of said printed wiring board (16; 50) and said lead (22) do not directly reflect on said optical axis, whereas reflection from said solder fillets (24, 26) reflects on said optical axis thus creating an optical solder joint image with dark areas representing said flat surfaces (52, 54, 56) and bright bands (58, 60) representing said concave fillet surfaces;
- transducing said optical image to a digitized optical information;
- analyzing said digitized optical information to evaluate the adequacy of said solder joint by detecting completeness of said bands (58, 60) along said component leads (22); and
- generating a completion and acceptance signal when said completeness corresponds to a continuous band along a predetermined proportion of the total fillet length.

6. The method of claim 5, characterized by repositioning said printed wiring board (16; 50) after the completion and acceptance signal has been produced to place a new pad (18) for optical inspection.

## Patentansprüche

1. Optisches Inspektionssystem, mit:
- einer Haltevorrichtung (12,14) für die Aufnahme einer gedruckten Leiterplatte (16;50) mit darauf befindlichen oberflächenbefestigten Bauteilen (20), welche mit Lötverbindungen versehen sind;
- einem opto-elektronischen Wandler (30,32), der eine bezogen auf die Haltervorrichtung (12,14) senkrechte Inspektionsachse definiert und so positioniert ist, daß er längs der Inspektionsachse ein optisches Lötstellenbild empfängt, sowie dazu angepaßt ist, das optische Lötstellenbild in ein elektronisches Bildsignal zu konvertieren;
- einer Lichtquelle, die zwischen der gedruckten Leiterplatte (16;50) und dem opto-elektronischen Wandler (30,32) positioniert ist, um die Lötverbindung bezogen auf die Inspektionsachse derart zu beleuchten, daß Licht aus der Lichtquelle auf ebene Flächen (52,54,56) der Platte (16;50) bzw. von länglichen Bauteilzuführungen (22) unter einem bezogen auf die ebenen Flächen (52,54,56) flachen Winkel fällt, um eine Reflexion von diesen Flächen in den opto-elektronischen Wandler (30,32) zu verhindern, während aus der Lichtquelle auf konkave Flächen von den länglichen Bauteilzuführungen (22) benachbarten Lötverbindungs-kehlnähten (24,26) fallendes Licht in den optoelektronischen Wandler (30,32) reflektiert wird und so das optische Lötstellenbild erzeugt, wobei dunkle Bereiche die ebenen Flächen (52,54,56) und helle Bänder (58,60) die konkaven Kehlnahtflächen repräsentieren;
- Mitteln (38), um das elektronische Bildsignal zu digitalisieren und selbiges in eine digitalisierte Information zu konvertieren;
- Mitteln (38) zum Analysieren der digitalisierten Information, um die Zweckdienlichkeit der Lötverbindung zu bewerten, wobei die analysierenden Mittel (38) dazu eingerichtet sind, die Vollständigkeit der Bänder (58,60) längs der Bauteilzuleitungen (22) zu detektieren; und
- einer Fertigsignalvorrichtung, welche ein Fertig- und Abnahmesignal erzeugt, wenn die Vollständigkeit einem kontinuierlichen Band längs eines vorbestimmten Abschnittes der gesamten Kehlnahtlänge entspricht.

2. System nach Anspruch 1, dadurch gekennzeichnet, daß die Lichtquelle eine um die Achse angeordnete ringförmige Fluoreszenzlampe (34) mit geringem Durchmesser und von hoher Intensität ist.

3. System nach Anspruch 2, dadurch gekennzeichnet, daß die ringförmige Fluoreszenzlampe (34) dicht oberhalb der Haltevorrichtung (12,14) positioniert ist, um eine im wesentlichen völlig um die Achse herumgehende flachwinklige diffuse Beleuchtung zu erzeugen.

4. System nach einem der Ansprüche 1 bis 3, dadurch gekennzeichnet, daß die Haltevorrichtung ein Positioniertisch (12,14) ist und daß die analysierenden Mittel (38) mit dem Positioniertisch (12,14) verbunden sind, so daß dann, wenn die Analyse einer Lötverbindung vollendet ist, der Positioniertisch (12,14) auf das Auftreten des Fertig- und Abnahmesignales hin sich in eine Position bewegt, wo eine neue Anschlußfläche (18) und ihre Bauteilzuleitung (22) in der Achse liegen.

5. Verfahren zum optischen Inspizieren einer Lötverbindung, mit den Schritten.
- Positionieren einer gedruckten Leiterplatte (16;50) in einer Inspektionsachse sowie senkrecht dazu, wobei die gedruckte Leiterplatte eine Anschlußfläche (18) mit einer auf der Anschlußfläche (18) befindlichen Bauteilzuleitung (22) trägt, die bestimmungsgemäß an die Anschlußfläche (18) mittels Lötkehlnähten (24,26) angelötet ist, die sich längs der Zuleitung (22) zwischen der Anschlußfläche (18) und der Zuleitung (22) erstrecken, wobei die gedruckte Leiterplatte (16;50) und die Zuleitung (22) ebene Flächen (52,54,56) aufweisen, während die Kehlnähte (24,26) konkave Flächen haben;
- Positionieren einer Lampe (34), um für flachwinkliges Licht auf der Anschlußfläche (18) zu sorgen, so daß Reflektionen von den ebenen Flächen (52,54,56) der gedruckten Leiterplatte (16;50) und der Zuleitung (22) nicht direkt in der optischen Achse reflektiert werden, während Reflektionen von den Lötkehlnähten (24,26) in der optischen Achse reflektiert werden, wodurch ein optisches Lötstellenbild mit die ebenen Flächen (52,54,56) repräsentierenden dunklen Bereichen und die konkaven Kehlnahtflächen repräsentierenden hellen Bändern (58,60) erzeugt wird;
- Umwandeln des optischen Bildes in eine digitalisierte optische Information;
- Analysieren der digitalisierten optischen Information, um die Zweckdienlichkeit der Lötverbindung dadurch zu bewerten, daß die Vollständigkeit der Bänder (58,60) längs der Bauteilzuleitungen (22) detektiert wird; und
- Erzeugen eines Fertig- und Abnahmesignales, wenn die Vollständigkeit einem kontinuierlichen Band längs eines vorbestimmten Abschnitts der gesamten Kehlnahtlänge entspricht.

6. Verfahren nach Anspruch 5, gekennzeichnet durch das erneute Positionieren der gedruckten Leiterplatte (16;50) nachdem das Fertig- und Abnahmesignal erzeugt wurde, um eine neue Anschlußfläche (18) für die optische Inspektion zu plazieren.

## Revendications

1. Système d'inspection optique comportant :
- des moyens de support (12, 14) pour le positionnement d'une plaquette (16 ; 50) à câblage imprimé portant des composants (20) montés en surface pourvus de joints soudés ;
- un transducteur opto-électronique (30, 32) définissant un axe d'inspection normal par rapport auxdits moyens (12, 14) de support et positionné de façon à recevoir une image optique d'un joint soudé le long dudit axe d'inspection et conçu pour convertir ladite image optique du joint soudé en un signal d'image électronique ;
- une source de lumière placée entre ladite plaquette (16 ; 50) à câblage imprimé et ledit transducteur opto-électronique (30, 32) pour éclairer ledit joint soudé par rapport audit axe d'inspection de manière que de la lumière provenant de ladite source de lumière tombe sur des surfaces plates (52, 54, 56) de ladite plaquette (16 ; 50) et de conducteurs allongés (22) de composants, respectivement, sous un petit angle par rapport auxdites surfaces plates (52, 54, 56) afin d'empêcher une réflexion à partir de celles-ci dans ledit transducteur opto-électronique (30, 32), alors que de la lumière provenant de ladite source de lumière et tombant sur des surfaces concaves de congés (24, 26) de joints soudés contiguës auxdits conducteurs allongés (22) de composants, est réfléchie dans ledit transducteur opto-électronique (30, 32), engendrant ainsi ladite image optique de joint soudé avec les zones sombres représentant les surfaces plates (52, 54, 56) et des bandes claires (58, 60) représentant lesdites surfaces concaves des congés ;
- des moyens (38) destinés à numériser ledit signal d'image électronique et à le convertir en une information numérisée ;
- des moyens (38) destinés à analyser ladite information numérisée pour évaluer la qualité dudit joint soudé, lesdits moyens d'analyse (38) étant contigus de façon à détecter l'état complet desdites bandes (58, 60) le long desdits conducteurs (22) de composants ; et
- des moyens à signal d'achèvement générant un signal d'achèvement et d'acceptation lorsque ledit état complet correspond à une bande continue le long d'une proportion prédéterminée de la longueur totale du congé.

2. Système selon la revendication 1, caractérisé en ce que ladite source de lumière est une lampe circulaire (34) à fluorescence, à haute intensité, faible diamètre, placée autour dudit axe.

3. Système selon la revendication 2, caractérisé en ce que ladite lampe circulaire (34) à fluorescence est placée étroitement au-dessus desdits moyens (12, 14) de support pour produire un éclairage diffusant sous un petit angle pratiquement tout autour dudit axe.

4. Système selon l'une quelconque des revendications 1 à 3, caractérisé en ce que lesdits moyens de support comprennent une table (12, 14) de positionnement et en ce que lesdits moyens d'analyse (38) sont connectés à ladite table (12, 14) de positionnement de manière que, lorsque l'analyse d'un joint soudé est achevée, ladite table (12, 14) de positionnement, à la suite de l'apparition du signal d'achèvement et d'acceptation, se déplace jusqu'à une position dans laquelle un nouveau plot (18) et son conducteur (22) de composant se trouvent sur ledit axe.

5. Procédé d'inspection optique d'un joint soudé, comprenant les étapes qui consistent :
- à positionner sur un axe d'inspection et normalement à celui-ci une plaquette (16 ; 50) à câblage imprimé portant un plot (18) avec un conducteur (22) de composant sur ledit plot (18) soudé à dessein audit plot (18) au moyen de congés (24, 26) de soudure s'étendant le long dudit conducteur (22) entre ledit plot (18) et ledit conducteur (22), ladite plaquette (16 ; 50) à câblage imprimé et ledit conducteur (22) ayant des surfaces plates (52, 54, 56) alors que lesdits congés (24, 26) ont des surfaces concaves ;
- à positionner une lampe (34) pour appliquer de la lumière sous un petit angle sur ledit plot (18) afin qu'une réflexion à partir desdites surfaces plates (52, 54, 56) de ladite plaquette (16 ; 50) à câblage imprimé et dudit conducteur (22) ne se réfléchisse pas directement sur ledit axe optique, alors qu'une réflexion provenant desdits congés (24, 26) de soudure, se réfléchisse sur ledit axe optique, engendrant ainsi une image optique du joint soudé avec des zones sombres représentant lesdites surfaces plates (52, 54, 56) et des bandes claires (58, 60) représentant lesdites surfaces concaves des congés ;
- à traduire ladite image optique en une information optique numérique ;
- à analyser ladite information optique numérisée pour évaluer la qualité dudit joint soudé en détectant l'état achevé desdites bandes (58, 60) le long desdits conducteurs (22) de composants ;
- à générer un signal d'achèvement et d'acceptation lorsque ledit état achevé correspond à une bande continue le long d'une proportion prédéterminée de la longueur totale du congé.

6. Procédé selon la revendication 5, caractérisé en ce qu'il consiste à repositionner ladite plaquette (16 ; 50) à câblage imprimé après que le signal d'achèvement et d'acceptation a été produit pour placer un nouveau plot (18) pour une inspection optique.
